Europäisches Patentamt

European Patent Office

Office européen des brevets

(19)

(11) Publication number: 0 364 163
A2

## (12) EUROPEAN PATENT APPLICATION

(21) Application number: 89310211.1

(22) Date of filing: 05.10.89

(51) Int. Cl.⁵: H01L 31/021 , H01L 31/167

(30) Priority: 14.10.88 US 257671

(43) Date of publication of application:
18.04.90 Bulletin 90/16

(84) Designated Contracting States:
DE ES FR GB NL SE

(71) Applicant: AMERICAN TELEPHONE AND
TELEGRAPH COMPANY
550 Madison Avenue
New York, NY 10022(US)

(72) Inventor: Banak, Michael Alan
P.O. Box 142
Mount Aetna Pennsylvania 19544(US)
Inventor: Zaneski, Gerard
4455 Eighth Avenue 2nd Floor Apt.
Temple Pennsylvania 19560(US)

(74) Representative: Johnston, Kenneth Graham et
al
AT&T (UK) LTD. AT&T Intellectual Property
Division 5 Mornington Road
Woodford Green Essex, IG8 OTU(GB)

(54) Electro-optic device including opaque protective regions.

(57) An opto-electronic device is disclosed wherein
light-sensitive portions (e.g., 24) of the integrated
electronics (e.g., 20) are covered with a non-conduc-
tive opaque protection layer (e.g., 40). This layer
thus prevents any light radiating from the input de-
vice (LED, for example) from impinging the surface
of the sensitive circuits. The opaque protection ma-
terial may comprise a layer of exposed photoresist,
applied to the circuit at the completion of the con-
ventional fabrication process.

EP 0 364 163 A2

## Electro-Optic Device Including Opaque Protective Regions

### Background of the Invention

#### 1. Field of the Invention

The present invention relates to opto-electronic devices and, more particularly, to a means for protecting the optically-sensitive electronic portions of such devices.

#### 2. Description of the Prior Art

In the field of opto-electric devices, solid-state relays and opto-isolators are two components which are becoming increasingly in demand. Solid-state relays (SSRs) may be used to replace conventional mechanial relays, since the solid state devices have no moving parts, can withstand extremely high voltages, and can be integrated to provide an extremely small final package size. Opto-isolators are often used in low speed data transmission systems as current sensing devices. In principle, these devices function by utilizing an LED in the input electrical circuit and a corresponding photosensitive device (a PIN diode, for example) connected to the output electrical circuit. As long as the input LED is inactive, the output PIN will also remain "off", thus isolating the output circuit from the input circuit. Once the LED is turned "on" by the input electrical circuit, the radiation from the LED will illuminate the PIN, thus activating the output circuit. U.S. Patent 4,303,831 issued to M. A El Hamamsy on December 1, 1981 describes in detail an optically triggered switch employing the technique outlined above.

In order to insure that the maximum amount of light generated by the LED reaches the PIN, opto-electric devices are usually encapsulated by a dome-shaped member. Preferably, the member is at least internally coated with a layer of white material to provide increased light transfer. The use of such a white coating is disclosed in U.S. Patent 4,114,177 issued to W. C. King on September 12, 1978.

A problem with the operation of some opto-electric devices results from the fact that portions of the output electronic circuit may be fatally sensitive to any illumination by the LED. For example, it has been discovered that integrated circuits such as bias networks, control circuits, and the like will begin to malfunction and immediately cease operation upon being illuminated. If the device is encapsulated by a dome-shaped cover, as described above, it is highly likely that these sensitive circuits will receive at least a portion of the light emitted by the LED. U.S. Patent 4,535,251 issued to T. Herman et al. on August 13, 1985 illustrates a solid state relay design wherein the dome cover is configured to encapsulate only the optical devices, that is, the LED and PIN. Thus, no light emitted by the LED will reach the electronic circuitry located outside of the dome. In theory, this is a viable solution. In practice, however, it is very difficult to control the encapsulated material so that only the optical devices are covered. Often, at least a portion of the electronics will also be encapsulated.

Therefore, a need remains in the prior art for some means of protecting the electronic portion of opto-electronic devices from light-induced failures. Obviously, without some means of protecting these circuits, opto-electronic devices will find rather limited use.

### Summary of the Invention

The problem remaining in the prior art is addressed by the present invention which relates to opto-electronic devices and, more particularly, to a means for protecting the optically-sensitive electronics associated with such devices. In accordance with the present invention, light-sensitive areas of the output circuit in an opto-electronic device are coated with material which is sufficiently opaque so as to prevent light which would damage the surface of the sensitive circuitry from reaching it. Many different types of coating or layer may be utilized, as long as the coating does not interact or interfere with the electrical performance of the underlying circuit. The coating or layer is preferably one non-conductive coating.

In a preferred embodiment of the present invention, a photolithography-defined sufficiently opaque coating, applied during the actual device fabrication process, is utilized. Commonly used carbonized photoresist is an example of opaque coating which may be applied during the device fabrication process.

In an alternative embodiment of the present invention, another sufficiently opaque coating, such as a grey room-temperature vulcanized (RTV) epoxy, may simply be applied to the sensitive areas subsequent to the completion of the device fabrication process.

These and further alternatives of the present invention will become apparent during the course of the following discussion and by reference to the accompanying drawings.

## Brief Description of the Drawing

Referring now to the drawings, where like numerals represent like parts in several views:

FIG. 1 illustrates, in an isometric view, an exemplary prior art onto-electronic device including designated areas of the output electrical circuit which are fatally sensitive to light;

FIG. 2 is a circuit diagram of a particular arrangement which may be included in the device of FIG. 1;

FIG. 3 is a cut-away side view of the device of FIG. 1, illustrating the various areas of the integrated circuits and the location of the light shield of the present invention;

FIGS. 4-6 illustrate an exemplary process of applying the inventive opaque protective coating during the integrated circuit fabrication process; and

FIG. 7 is illustrative of an exemplary opto-electronic device including an opaque protective coating applied subsequent to the integrated circuit fabrication process.

## Detailed Description

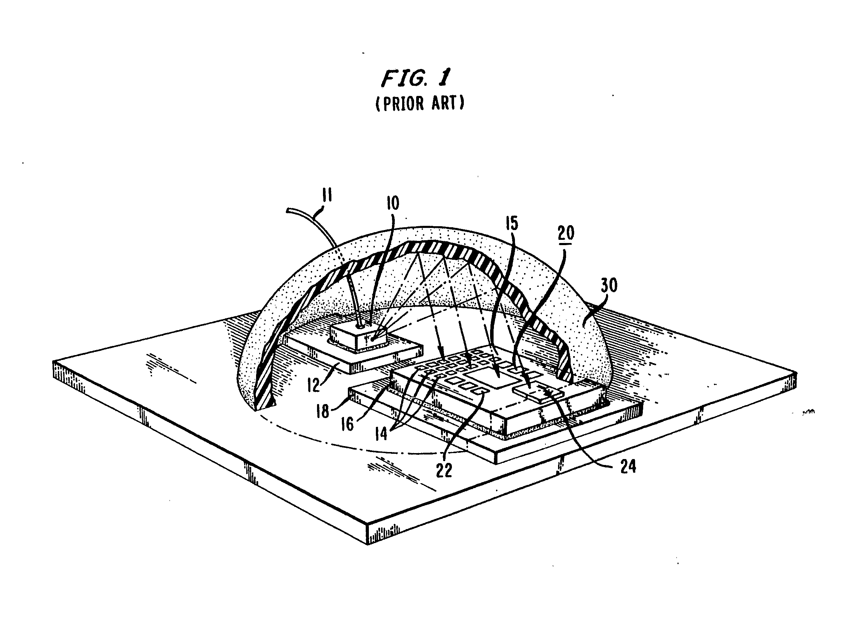

An exemplary opto-electronic device is illustrated in FIG. 1. The device include an LED 10 mounted on a first lead frame 12, lead frame 12 forming the first electrical connection to LED 10. The remaining electrical input the LED 10 is provided by a wire bond 11 to the top surface of LED 10. The photosensitive receiving element is illustrated in FIG. 1 as a photodiode array 14. Photodiode array 14 is formed in the top surface 15 of a semiconductor substrate 16, where substrate 16 is attached to a second lead frame 18. Also formed in substrate 16 is the receiving electronics 20, which include non-light-sensitive circuitry 22 and light-sensitive circuitry 24. As shown in FIG. 1, the device is covered by a dome-like structure 30 which increases the operating efficiency of the device by transferring a larger percentage of the LED's output radiation to photodiode array 14.

In operation, an electrical input signal will stimulate LED 10 to provide an optical output signal which illuminates top surface 15 of substrate 16, including photodiode array 14. As shown in FIG. 1, at least a portion of the emitted light will strike light-sensitive circuitry 24. In this particular example illustrated in FIG. 1, cover 30 is shown to encapsulate only a portion of sensitive circuitry 24. As stated above, the process of applying this dome cannot be well-controlled, so that each opto-electronic device of the type illustrated in FIG. 1 will more than likely have a different amount of circuitry 24 exposed to illumination by LED 10.

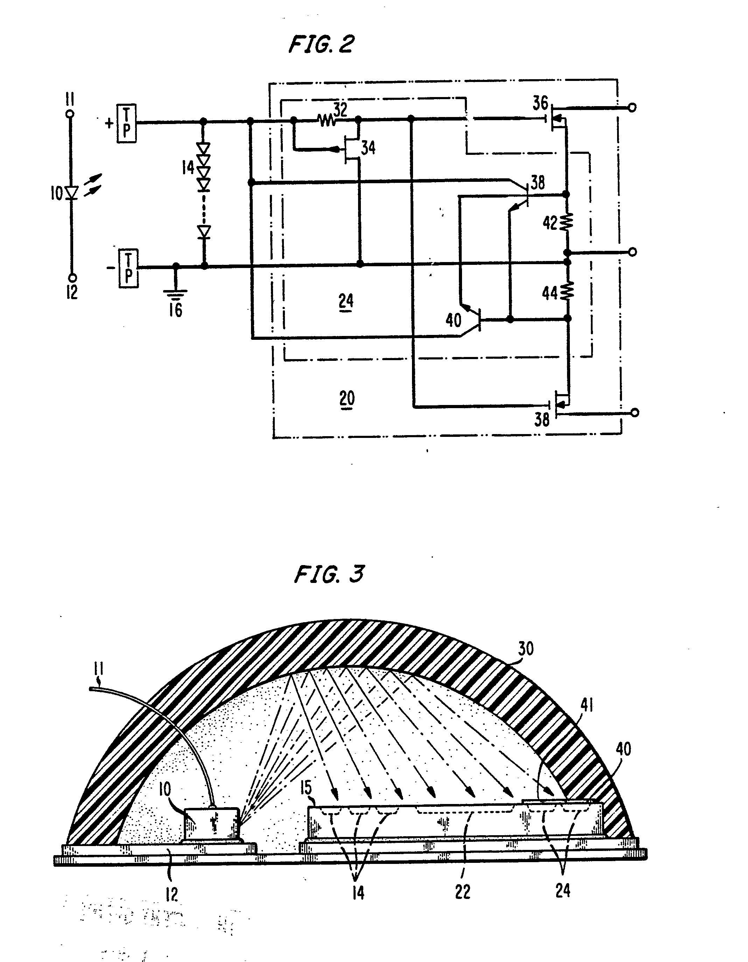

FIG. 2 is illustrative of a particular opto-electronic device which may be included in the arrangement of FIG. 1. Illustrated in FIG. 2 is input LED 10, where one side of LED 10 is attached via wire bond 11 to the electrical input signal; the other side of LED 10 is similarly attached via lead frame 12. Photodiode array 14 is schematically illustrated as connected between substrate 16 and one terminal of electronic circuitry 20. The non-light-sensitive circuitry 22, in this case the actual switching circuitry, is illustrated in FIG. 2 as comprising a pair of output MOS FETs 36 and 38. The light-sensitive circuitry 24 in this particular example comprises control circuitry consisting of bias arrangement 32, 24, a pair of bipolar transistors 38,40 and a pair of biasing resistors 42,44.

As stated above, the opaque protection layer of the present invention will ensure that light-sensitive circuitry 24 will continue to operate, regardless of the amount of light emitted by LED 10 which reaches the surface of circuitry 24. FIG. 3 illustrates a cross-sectional view of the opto-electronic device of FIG. 1, including a non-conductive protection layer 40 which is disposed to cover circuitry 24. When LED 10 is activated, any emitted light which strikes top surface 41 of protective layer 40 will be reflected or absorbed by protection layer 40 and prevented from reaching the underlying electronic circuitry 24.

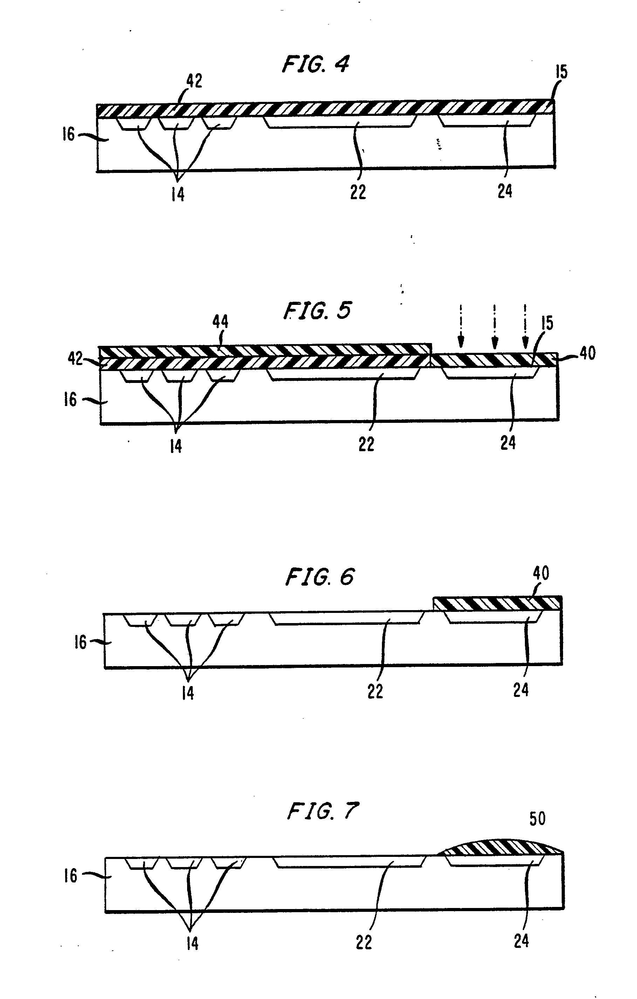

As mentioned above, protection layer 40 may comprise exposed photoresist which is photolithographically defined to cover circuitry 24 and is applied to substrate 16 at the end of the conventional device fabrication process. One exemplary process of applying protection layer 40 is illustrated in FIGs. 4-6. In particular, subsequent to the formation of photodiodes 14 and circuitry 22,24 in substrate 16, top surface 15 of substrate 16 is covered with a layer of photoresist 42, as illustrated in FIG. 4. A patterning layer 44 covering photodiodes 14 and non-sensitive circuitry 22 is then disposed over photoresist layer 44. The substrate at this point in the fabrication process is illustrated in FIG. 5. The photoresist is then exposed in a usual fashion well-known in the prior art. Patterning layer 44 and the underlying unexposed photoresist 42 are then removed using a common etchant, leaving protective layer 40 covering light-sensitive circuitry 24. The structure is then heated at an elevated temperature sufficient to carbonize the photoresist and render it sufficiently opaque. This final structure, as illustrated in FIG. 6, is identical in form to substrate 16 as illustrated in FIG. 3. It is to be noted that protective layer 40 may also cover portions of non-light sensitive circuitry 22 without affecting its performance. Thus, patterning layer 44 need not be very precise in determining the exact boundaries of sensitive circuitry 44. As long as photodiode array 14 remains completely exposed to the light and sensitive circuitry 24 is protected, the opto-electronic device will operate properly.

The inventive protective layer, as stated above, may also comprise any type of non-conductive opaque material which is applied subsequent to the device fabrication process. for example a gray RTV compound 50, as shown in FIG. 7, may be dropped onto top surface 15 of substrate 16 immediately prior to the formation of dome encapsulate 30. As with photolithographically-defined protective layer 40, as long as protective encapsulate 50 completely covers light-sensitive circuitry 24, the opto-electronic device will operate properly. In some instances, however, this latter type of protective layer may be less acceptable, since it requires a manual operation to correctly deposit the encapsulate and is likely to be more time-consuming and less exact.

Utilizing either type of protective layer, or any other such sufficiently opaque material, it is necessary that such material in its final form be non-conductive. This criteria is especially important when high-speed, light-sensitive circuitry is being protected. This is due to the fact that many of these devices include a covering layer of an insulating material (silicon dioxide, for example). If the protective layer were formed of a conductive substance, the combination of the protective layer, the underlying insulating material, and the metal interconnections within the circuitry will result in the formation of a number of unwanted capacitors which may unknowingly couple together various parts of the light-sensitive circuitry. This problem becomes especially troublesome at higher frequencies, since the value of the created capacitance will increase as the frequency increases. Thus, it is important, in accorance with the teachings of the present invention, that a non-conductive protective layer be utilized.

## Claims

1. An electro-optic device comprising
a light transmitting device (e.g. 10) for emitting a light output signal in response to an electrical input signal;
a light receiving device (e.g. 14) responsive to said light output signal for transforming said light output signal into an equivalent electrical output signal; and
circuit means (e.g. 20) responsive to said electrical output signal, wherein at least a portion (e.g. 24) of said circuit means is sufficiently sensitive to light exposure that it could be damaged thereby;
CHARACTERIZED IN THAT
the electro-optic device further comprises
a protection layer (e.g. 40) disposed to cover at least said sensitive portion of said circuit means, said protection layer being sufficiently opaque so as to prevent said light output signal from damaging the performance of said sensitive portion of said integrated circuit means.

2. An electro-optic device as defined in claim 1 wherein said protection layer comprises a photoresist material applied subsequent to the integrated circuit fabrication process.

3. An electro-optic device as defined in claim 2 wherein the photoresist is heated to an elevated temperature so as to render said photoresist sufficiently opaque.

4. An electro-optic device as defined in claim 1 wherein said protection layer comprises a room-temperature volcanized (RTV) material.

## FIG. 1
## (PRIOR ART)

EP 0 364 163 A2

*FIG. 2*

*FIG. 3*

*FIG. 4*

42

15

16

14    22    24

*FIG. 5*

44

42    15

40

16

14    22    24

*FIG. 6*

40

16

14    22    24

*FIG. 7*

50

16

14    22    24